# FASCICULE DE BREVET EUROPEEN

(11) **EP 0 507 742 B1**
(45) Date de publication et mention de la délivrance du brevet: **23.10.1996**
(21) Numéro de dépôt: 92810243.3
(22) Date de dépôt: 01.04.1992
(51) Int. Cl.: G02F 1/00

(54) **Capteur optique de courant électrique**
Optischer Stromsensor
Optical sensor for electric current

(30) Priorité: 04.04.1991 CH 999/91
(43) Date de publication de la demande: 07.10.1992
(73) Titulaire: CENTRE SUISSE D'ELECTRONIQUE ET DE MICROTECHNIQUE S.A., 2007 Neuchâtel (CH)
(72) Inventeur: Parriaux, Olivier, CH-1005 Lausanne (CH); Debergh, Patrick, CH-2088 Cressier (CH); Chavanne, Jean-Pascal, CH-2503 Bienne (CH)
(74) Mandataire: Brulliard, Joel

(56) Documents cités:
- EP-A- 0 023 180
- EP-A- 0 108 671
- EP-A- 0 356 670
- DE-A- 2 548 278
- ELECTRONICS LETTERS vol. 27, no. 3, 31 janvier 1991, STEVENAGE (GB) pages 207 - 208; 'current sensing by mode coupling in fibre via the faraday effect'
- PATENT ABSTRACTS OF JAPAN vol. 8, no. 121 (P-278)(1558) 7 juin 1984 & JP-A-59 027 266

## Description

La présente invention concerne, de manière générale, les capteurs à guide de lumière et, plus particulièrement, un capteur optique de courant électrique.

Les capteurs de courant électrique à effet Faraday de l'art antérieur utilisent une fibre monomode. Ladite fibre doit maintenir le caractère linéaire de la polarisation de l'onde, d'où l'utilisation d'une fibre optique non biréfringente ou très faiblement biréfringente.

Le fait que le coeur de la fibre ne soit pas parfaitement circulaire et que les contraintes accumulées lors du refroidissement à l'étirage de ladite fibre n'aient pas une symétrie rigoureusement circulaire, se caractérise par l'introduction d'une biréfringence intrinsèque dans ladite fibre optique.

De plus la fibre, étant enroulée autour du conducteur de courant électrique, possède une biréfringence supplémentaire appelée biréfringence de courbure.

Ces deux biréfringences linéaires ont l'inconvénient majeur de masquer et de brouiller l'effet Faraday recherché. Cet effet se manifeste dans un milieu non-biréfringent et sous l'action d'une ligne de champ magnétique colinéaire à la direction de propagation de l'onde lumineuse, par la rotation du vecteur de polarisation. Ladite ligne de champ magnétique peut être issue du champ magnétique circulaire produit par le courant électrique dans le conducteur.

Une solution proposée par S.C. Rashleigh et R. Ulrich dans l'article "MAGNETO-OPTIC CURRENT SENSING WITH BIREFRINGENT FIBERS", publié dans Applied Physic Letters, Vol. 34, No. 11, pp. 768 à 770 (1979), est la suppression des perturbations dues aux biréfringences linéaires. En d'autres termes, il s'agit de supprimer le caractère linéairement biréfringent du guide d'onde optique, ou de le dominer par une forte biréfringence circulaire. L'article montre l'utilisation d'une fibre torsadée. Dans une telle fibre, la biréfringence circulaire introduite permet de diminuer l'influence de la biréfringence linéaire de courbure et d'utiliser une fibre de longueur importante.

Une deuxième solution est proposée par L. Li et al dans l'article "CURRENT SENSORS USING HIGHLY BIREFRINGENT BOW-TIE FIBRES", publié dans Electronics Letters (1986), Vol. 22, No 21, pp. 1142-1144. L. Li et al montrent que l'on peut maîtriser les effets de la présence de la biréfringence linéaire interne et externe en utilisant une fibre optique dont la biréfringence elliptique est importante. Un tel guide de lumière est obtenu en torsadant, lors de son étirage, une fibre à haute biréfringence linéaire.

Dans de tels systèmes, la valeur du courant électrique se déduit de la mesure de la rotation du plan de polarisation.

D'autres solutions basées sur le même principe sont décrites, par exemple, dans les publications de
- M. Kuribara et al "CHARACTERISTICS OF TWISTED SINGLE-MODE OPTICAL FIBER FOR CURRENT SENSOR", Trans. Inst. Electron. and Commun. Eng. Jpn. Part C (Japan), Vol. J66C, No 2, Février 1973;
- A.M. Smith "POLARIZATION AND MAGNETOOPTIC PROPERTIES OF SINGLE-MODE OPTICAL FIBER", Applied Optics, Vol. 17, No 1, Janvier 1978 ou encore
- "OPTICAL FIBRES FOR CURRENT MEASUREMENT APPLICATIONS", Optics and Laser Technology, Février 1980, du même auteur.

Bien que la théorie des modes couplés soit connue et exposée dès 1973 par A. Yariv dans IEEE Journal of Quantum Electronics (Septembre 1973, pp. 919-933), ou plus récemment par Scott C. Rashleigh dans Journal of Lightwave Technology (Vol. LT-1, No 2, Juin 1983, pp. 312 - 331) et bien que des structures à couplage de modes, et leurs caractéristiques, soient connues et utilisées de longue date dans différents domaines (brevet US 3,891,302 délivré en juin 1975 et demande de brevet GB 2 125 572A déposée en août 1982), l'état de la technique montre que la plupart des capteurs de courant électrique à effet Faraday de l'art antérieur utilisent une fibre optique monomode et sont basés sur la suppression ou la domination des biréfringences linéaire intrinsèque et de courbure de ladite fibre optique.

L'article, intitulé "Current Sensing by Mode Coupling in Fibre via the Faraday Effect" et paru dans Electronics Letters, Vol. 27, No. 3, pp 207-208 du 31 janvier 1991, décrit une méthode, pour contourner les effets dûs à la biréfringence de courbure ou intrinsèque de la fibre, qui consiste à engendrer une modulation spatiale périodique agissant sur la fibre. Cette pertubation périodique est produite par les enroulements correctement espacés du conducteur de courant. On conçoit aisément qu'une telle méthode est difficilement applicable dans le cas d'un conducteur rectiligne.

Un objet de l'invention est un capteur optique de courant électrique s'affranchissant de la biréfringence linéaire intrinsèque et de la biréfringence linéaire de courbure ainsi que de leur fluctuation et comportant une fibre optique assujettie à une pertubation spatiale périodique.

Le capteur optique de courant électrique de l'invention se compose de moyens émetteurs, de moyens transmetteurs disposés autour d'un conducteur de courant électrique (1) et de moyens récepteurs et est caractérisé par des moyens transducteurs réalisés en un matériau magnétique et engendrant une modulation spatiale, le long desdits moyens transmetteurs, du champ magnétique, à une période spatiale égale à un nombre entier de fois la longueur de battement L_{B} des moyens transmetteurs sous contrainte.

Un avantage de l'invention réside dans l'utilisation de la courbure même du guide de lumière autour du conducteur de courant électrique, pour engendrer la périodicité du couplage. La biréfringence linéaire de courbure issue de ladite courbure du guide n'est donc plus à supprimer ni à dominer.

Un autre avantage d'une telle configuration du capteur est sa faible sensibilité aux vibrations.

Un autre avantage d'une telle configuration est la possibilité de détecter des courants électriques faibles.

Un avantage de la modulation de la biréfringence du guide de lumière conformément à l'invention, est l'utilisation possible d'une technologie d'intégration sur substrat plan par transfert photolithographique de masques.

D'autres objets, caractéristiques et avantages de la présente invention apparaîtront plus clairement à la lecture de la description suivante, faite en relation avec le dessin joint. Celui-ci montre un capteur de courant électrique, à guide de lumière, pour lequel :

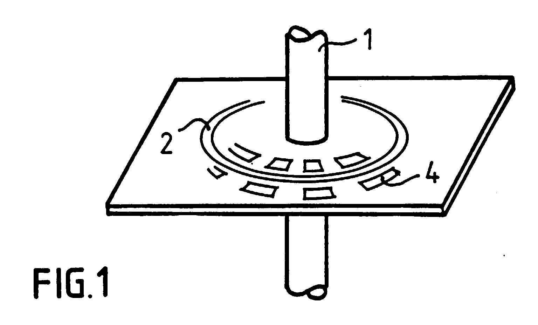

- Fig. 1: le champ magnétique est modulé spatialement par la présence de zones magnétiques.

De manière générale, le capteur optique de courant électrique de l'invention se compose de moyens émetteurs, de moyens transmetteurs, de moyens transducteurs et de moyens récepteurs.

Pour toutes réalisations entrant dans le cadre de la présente invention, la période spatiale dont il est fait mention tout au long de la description est égale à un nombre entier de fois la longueur de battement du guide de lumière.

La fig. 1 montre un capteur de courant électrique comportant un guide de lumière biréfringent 2 bobiné autour d'un conducteur de courant électrique 1. La structure optique ainsi réalisée est constituée d'une ou de plusieurs spires. Un matériau magnétique, créant des zones de concentration 4 du champ magnétique, est réparti périodiquement le long du coeur dudit guide, à une période spatiale égale à un nombre entier de fois la longueur de battement L_{B} du guide de lumière.

Le capteur de courant électrique de l'invention est représenté à la figure 1, laquelle illustre le principe de fonctionnement suivant.

Ce principe de fonctionnement est basé sur l'obtention d'un couplage entre modes de polarisation, grëce à une modulation spatiale périodique du champ magnétique le long du guide de lumière, de période égale à la longueur de battement L_{B} dudit guide.

Le formalisme associé à la théorie des modes couplés est exprimé par A. Yariv et S.C. Rashleigh dans les articles cités précédemment. Ce formalisme s'applique aux phénomènes de propagation et d'interaction des ondes optiques dans un guide d'onde diélectrique. Les auteurs expliquent qu'en présence de perturbations, la puissance lumineuse se propageant dans un guide de lumière est transmise d'un mode à un autre. Les perturbations sont, par exemple, un champ électrique périodique, une onde acoustique, ou encore une ondulation de surface.

Pour le capteur de courant électrique selon l'invention, le couplage entre les deux modes de polarisation orthogonale est tributaire :
- d'une part du coefficient de couplage K entre lesdits modes, lequel est non nul dans le cas où un effet physique de couplage existe et
- d'autre part, dans le cas d'un guide d'onde biréfringent, d'un synchronisme entre les deux ondes se traduisant par l'égalité entre les vitesses de phase de chaque onde.

Le coefficient de couplage K est donné par l'expression K = 2VH dans laquelle V est la constante de Verdet du matériau où se propage la lumière et H est le champ magnétique engendré par le courant I à mesurer.

L'effet physique de couplage pour lequel le coefficient de couplage est non nul, est ici procuré par l'effet Faraday. La restauration du synchronisme entre les deux ondes est provoquée par l'introduction d'une perturbation spatiale périodique le long du guide biréfringent - à savoir une modulation du champ magnétique B - à une période égale à la longueur de battement L_{B} du guide.

La modulation dudit champ magnétique correspond en fait à une modulation du coefficient de couplage K entre les modes de polarisation. L'effet d'une modulation du coefficient de couplage K le long dudit guide, à une période spatiale égale à la longueur de battement L_{B}, se caractérise par une accumulation et non une compensation des contributions élémentaires de chaque période au couplage global recherché. En effet, à chaque alternance positive correspond un couplage de modes, appelé couplage aller, et à chaque alternance négative correspond un couplage de modes inverse, appelé couplage retour. Du fait de la modulation du coefficient de couplage, le couplage retour lors de chaque demi-période est donc soit nul, soit faible, d'où un effet global de couplage non nul sur chaque période.

Dans un mode de réalisation préféré du capteur de courant électrique, les moyens émetteurs sont, par exemple, une diode laser associée à un polariseur linéaire. Les moyens transmetteurs sont, par exemple, un guide de lumière monomode biréfringent dans lequel est injecté un mode de polarisation préalablement sélectionné. Les moyens récepteurs sont, par exemple, un élément séparateur de polarisation associé à deux détecteurs optiques. Les deux modes de polarisation orthogonale se présentant en sortie du guide de lumière, sont séparés puis détectés par les deux détecteurs optiques. La mesure des intensités lumineuses de chaque mode de polarisation renseigne sur le couplage entre modes et donc sur la valeur du courant électrique ayant induit ce couplage par effet Faraday.

Un mode de réalisation préféré des moyens transducteurs tels que montrés à la fig. 1 peut utiliser un guide optique intégré sur un substrat passif, par exemple sur une plaquette de silicium. La technologie des échanges ioniques dans les verres, décrite par J.-E. Gortych et al, "FABRICATION OF PLANAR OPTICAL WAWEGUIDES BY K⁺ ION EXCHANGE IN BK7 GLASS", Optics Letters, Vol. 11, No 2, Février 1986, pp. 100-102, peut être utilisée. De plus, une couche de matériau magnétique est déposée, par exemple sur ledit guide optique intégré. Une technologie possible est le dépôt d'un matériau tel qu'une ferrite ou du mu-métal par photolithographie. Ladite couche de matériau magnétique peut également, et de manière préférentielle, être déposée de part et d'autre dudit guide optique intégré, par exemple dans des cavités aménagées dans le substrat. Lesdites cavités ont des formes diverses, par exemple rectangulaire, de manière à ce que le champ magnétique se concentre dans ces cavités.

Conformément à la théorie des modes couplés, le guide de lumière pouvant être utilisé dans le capteur de courant électrique de l'invention peut être indifféremment un guide d'onde optique intégré ou une fibre optique à revêtement. Ces guides de lumière propagent deux modes de polarisation orthogonale.

## Revendications

1. Capteur optique de courant électrique composé de moyens émetteurs de lumière, de moyens transmetteurs de lumière (2) disposés autour d'un conducteur de courant électrique (1) produisant un champ magnétique circulaire dont les lignes de champ sont colinéaires à la direction de propagation de la lumière, de moyens transducteurs et de moyens récepteurs de lumière et tel que:
- les moyens émetteurs de lumière émettent une onde lumineuse comportant un mode de polarisation,
- les moyens transmetteurs de lumière propagent ladite onde lumineuse,
- les moyens transducteurs (4) engendrent une modulation spatiale, le long desdits moyens transmetteurs, du champ magnétique, à une période spatiale égale à un nombre entier de fois la longueur de battement L_{B} des moyens transmetteurs sous contrainte, ladite modulation créant un couplage entre les modes de polarisation,
- les moyens récepteurs de lumière détectent l'intensité desdits modes de polarisation;
ledit capteur optique étant caractérisé en ce que lesdits moyens transducteurs sont un matériau magnétique, disposé périodiquement le long desdits moyens transmetteurs à une période égale à un nombre entier de fois la longueur de battement, créant des zones de concentration (4) du champ magnétique et permettant une modulation spatiale du coefficient de couplage intermodal à une période spatiale égale audit nombre entier de fois la longueur de battement.

## Patentansprüche

1. Optischer Sensor für elektrischen Strom, bestehend aus Lichtaussendemitteln, Lichtübertragungsmitteln (2), die um einen einen elektrischen Strom führenden Leiter (1) herum angeordnet sind, der ein kreisförmiges Magnetfeld erzeugt, dessen Feldlinien kolinear sind zur Ausbreitungsrichtung des Lichtes, Wandlermittel und Lichtempfängermittel und derart, daß:
- die Lichtsendemittel eine Lichtwelle aussenden, die einen Polarisationsmodus umfaßt,
- die Lichtübertragungsmittel die Lichtwelle übertragen,
- die Wandlermittel (4) eine räumliche Modulation längs der Übertragungsmittel des Magnetfeldes erzeugen mit einer räumlichen Periode gleich einem ganzzahligen Vielfachen der Schwebungslänge L_{B} der Sendermittel unter Belastung, welche Modulation eine Kopplung zwischen den Polarisationsmoden erzeugt,
- die Lichtempfängermittel die Intensität der Polarisationsmoden erfassen,
welcher optische Sensor dadurch gekennzeichnet ist, daß die Wandlermittel ein magnetisches Material sind, periodisch angeordnet längs der Übertragungsmittel mit einer Periode gleich einem ganzzahligen Vielfachen der Schwebungslänge unter Erzeugung von Konzentrationszonen (4) des Magnetfeldes, und eine räumliche Modulation des Intermoduskopplungskoeffizienten mit einer räumlichen Periode gleich dem genannten ganzzahligen Vielfachen der Schwebungslänge ermöglichen.

## Claims

1. Optical detector for electrical current comprising light emitting means, light transmitting means (2) disposed around a conductor of electrical current (1) producing a circular magnetic field whose field lines are co-linear with the direction of propagation of the light, transducing means and receiving means for light and such that:
- the light emitting means emit a luminous wave comprising a mode of polarisation,
- the light transmitting means propagate the said luminous wave,
- the transducing means (4) generate a spatial modulation along the said transmitting means of the magnetic field, at a spatial period equal to a whole number of times the beat length LB of the transmitting means under stress, said modulation creating a coupling between the modes of polarisation,
- the light receiving means detect the intensity of the said modes of polarisation;
said optical sensor being characterised in that the said transducing means are a magnetic material disposed periodically along the said transmitting means at a period equal to a whole number of times the beat length, creating zones of concentration (4) of the magnetic field and enabling a spatial modulation of the inter-modal coupling coefficient at a spatial period equal to the said whole number of times the beat length.
